# EUROPEAN PATENT SPECIFICATION

(11) **EP 2 019 577 B1**
(45) Date of publication and mention of the grant of the patent: **30.06.2010**
(21) Application number: 07740537.1
(22) Date of filing: 30.03.2007
(51) Int. Cl.: H05K 3/46, H05K 9/00

(54) **MULTILAYER MODULE WITH CASE**
MEHRSCHICHTMODUL MIT GEHÄUSE
MODULE MULTICOUCHE AVEC BOITIER

(30) Priority: 17.05.2006 JP 2006138235
(43) Date of publication of application: 28.01.2009
(73) Proprietor: Murata Manufacturing Co. Ltd., Nagaokakyo-shi, Kyoto 617-8555 (JP)
(72) Inventor: TANAKA, Koji MURATA MANUFACTURING CO., LTD., Nagaokakyo-shi Kyoto-fu 617-8555 (JP)
(74) Representative: Zinkler, Franz
(86) International application number: PCT/JP2007/057101
(87) International publication number: WO 2007/132599

(56) References cited:
- JP-A- 07 263 892
- JP-A- 11 238 994

## Description

### Technical Field

The present invention relates to multilayer modules, and more particularly to a covered multilayer module which has a case arranged to cover a mount surface for mount devices of a multilayer module body in which the mount devices are mounted on a multilayer board.

### Background Art

Reduction in size of electronic components is being promoted these days. A widely used configuration of such electronic components meeting the size reduction is a multilayer module in which mount devices such as an IC chip and a capacitor are mounted on a multilayer board having three-dimensionally arranged inner conductors for a circuit, etc.

Such a multilayer board module includes a covered multilayer module having a case configured to cover the mount surface on which the mount devices such as the IC chip and the capacitor are mounted.

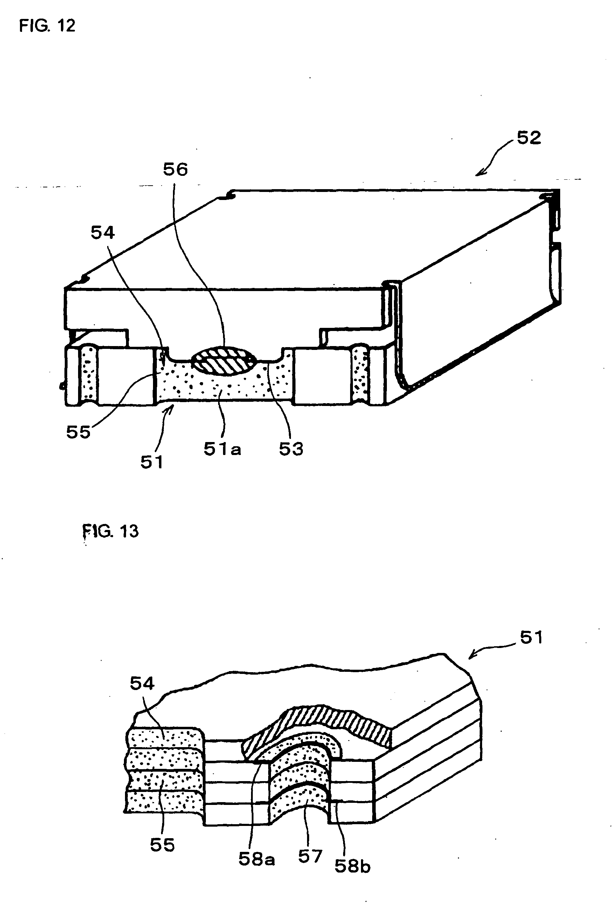

As shown in Fig. 12, an example of the covered multilayer module is suggested in which a claw portion 53 of a metal case 52 is bonded to a multilayer board 51 as the multilayer module body. In the covered multilayer module, the metal case 52 is attached to the multilayer board 51 by bonding the claw portion 53 of the metal case 52 using solder 56, to a ground electrode 55 which is formed by plating or baking in a recess 54 having a wide width and formed at a side surface 51a of the multilayer board 51 (see Patent Document 1).

In the above-described covered multilayer module, if the claw portion 53 of the metal case 52 is bonded to the ground electrode 55 having a wide width using the solder 56, the claw portion 53 can be reliably bonded to the wide-width ground electrode 55. However, when the wide-width ground electrode 55 is formed, the mass of the ground electrode 55 becomes large, and hence the ground electrode 55 may be detached from the side surface 51a of the multilayer board 51. Because of this, the reliability of bonding of the metal case 52 to the ground electrode 55 is not sufficient.

Meanwhile, a method of manufacturing a plurality of individual ceramic multilayer boards at a time, i.e., a method of manufacturing plural components at a time, may be employed. The method includes forming a through hole at a green mother multilayer board, which becomes a plurality of multilayer boards after dividing, filling the through hole with conductive paste similar to that for forming an inner conductor, firing the mother multilayer board and baking the conductor paste to form a through hole electrode, then dividing the mother multilayer board such that the through hole is cut in half, thus forming individual multilayer boards each having a bonding electrode for bonding the claw portion of the metal case in which the half-cut through holes (recesses) are filled with the conductor, and bonding the claw portion of the metal case to the bonding electrode of the individual multilayer board. In this way, the plurality of individual ceramic multilayer boards with the claw portions of the cases being bonded to the bonding electrodes are manufactured. In the case where the method is employed, the area (width) of the bonding electrode may not be sufficiently large.

In particular, when employing the method of manufacturing the plural components at a time, if the area (width) of the bonding electrode is increased, the diameter of the through hole has to be increased. In this case, the conductive paste filled in the through hole may be detached, and thus it is difficult to form the reliable bonding electrode having the large area. Consequently, when the claw portion of the metal case is soldered to the bonding electrode, the bonding strength of the metal case with respect to the multilayer board may be insufficient, or the solder bonding portion may be detached due to a load such as its mass, resulting in a low reliability.

In addition, even when the above-mentioned method of manufacturing the plural components is not employed, since the demand for reduction in size of the electronic components is being promoted, it is difficult to increase the width of the bonding electrode, for bonding the claw portion of the metal case, at the side surface of the multilayer board. If the claw portion of the metal case is soldered to a plurality of the bonding electrodes, it is still difficult to sufficiently secure the reliability of bonding.

As shown in Fig. 13, Patent Document 1 also discloses a configuration of a covered multilayer module, in which substantially U-shaped reinforcing conductors 58a and 58b are connected to an end electrode 57 formed at a narrow recess formed along a lamination direction, as a connection electrode to an external device, so as to provide reliable connection with the external device. The electrode is not for bonding the claw portion 53 of the metal case 52, and even if the electrode is used for bonding the claw portion 53 of the metal case 52, in the case where the end electrode 57 has a small width as shown in Fig. 13, it is difficult to provide a sufficient bonding strength.
Patent Document 1: Japanese Unexamined Patent Application Publication No. 06-252562

Patent Document 2, Japanese Unexamined Patent Application Publication No. 11-238994, discloses a covered multilayer module in which inner conductor layers are exposed on each side, the exposed part of the conductors being provided with electrodes to which the claws of the cover are attached.

### Disclosure of Invention

### Problems to be Solved by the Invention

The present invention is to solve the above-mentioned problems, and thus, an object of the present invention is to provide a highly reliable covered multilayer module capable of improving a bonding strength of a case with respect to a multilayer board without requiring a complicated structure or increasing in size of a product.

### Means for Solving the Problems

To solve the above-mentioned problems, a covered multilayer module according to the present invention (claim 1) includes a multilayer module body in which a mount device is mounted on a multilayer board, and a metal case arranged to cover at least one of principal surfaces of the multilayer module body. The multilayer module body has a plurality of laminated ceramic layers and at least one inner conductor layer, the inner conductor layer being formed between the ceramic layers. The multilayer module body has a shape defined by a pair of opposite principal surfaces and side surfaces connecting the pair of principal surfaces. A plurality of side electrodes extending in a lamination direction of the ceramic layers are provided at least at one of the side surfaces. At least one of the inner conductor layers is exposed at the side surface provided with the plurality of side electrodes, in a region interposed between an adjacently arranged pair of the side electrodes. The metal case has a top plate and a claw portion. The claw portion is formed to extend along the side surface of the multilayer module body provided with the side electrodes. The claw portion is soldered to the side electrodes and the inner conductor layer exposed at the side surface.

Based on the configuration of the invention of claim 1, in the covered multilayer module according to claim 2, the plurality of inner conductor layers are exposed at the side surface of the multilayer module body in the region interposed between the adjacently arranged pair of side electrodes such that at least a part of the inner conductor layer is superposed on the other inner conductor layer when seen in the lamination direction of the ceramic layers.

Based on the configuration of the invention of claim 1, in the covered multilayer module according to claim 3, the inner conductor layer is exposed at the side surface of the multilayer module body such that the inner conductor layer extends from one to the other of the adjacently arranged pair of side electrodes.

### Advantages

In the covered multilayer module according to the present invention (claim 1), the plurality of side electrodes extending in the lamination direction of the ceramic layers are provided at least at the one of the side surfaces of the multilayer module body. The at least one of the inner conductor layers is exposed at the side surface of the multilayer module body provided with the plurality of side electrodes, in the region interposed between the adjacently arranged pair of side electrodes. The claw portion of the metal case is soldered to the side electrodes of the multilayer module body and to the inner conductor layer exposed at the side surface. Accordingly, the highly reliable covered multilayer module can be provided in which the case has a large bonding strength with respect to the multilayer module body without requiring a complicated structure or increasing in size of a product.

In particular, in the covered multilayer module of the present invention, the at least one of the inner conductor layers is exposed at the side surface of the multilayer module body provided with the plurality of side electrodes, in the region interposed between the adjacently arranged pair of side electrodes. So, when the claw portion of the metal case is soldered to the plurality of side electrodes, the claw portion can be soldered not only to the side electrodes, but also to the inner conductor layer exposed at the side surface, and the inner conductor layer holds solder at the side surface of the multilayer module body. Therefore, the bonding strength of the metal case with respect to the multilayer module body can be improved without using a special member or increasing in size of a product to increase the area of the side electrodes, thereby obtaining a highly reliable covered multilayer module.

In the present invention, regarding the side electrodes, it should be noted that the expression, "the plurality of side electrodes extending in the lamination direction of the ceramic layers", means the arrangement of the side electrodes such that each of the plurality of side electrodes is formed at the plurality of ceramic layers to across the ceramic layers in the thickness direction, but does not mean that the external shape of the side electrode is long in the lamination direction of the ceramic layers. Hence, the shape of the side electrode is not limited to a specific shape.

Also, based on the configuration of the invention according to claim 1, like the covered multilayer module according to claim 2, the configuration is shown where the plurality of inner conductor layers are exposed at the side surface of the multilayer module body in the region interposed between the adjacently arranged pair of side electrodes such that at least the part of the inner conductor layer is superposed on the other inner conductor layer when seen in the lamination direction of the ceramic layers. In such a case, the flow of solder in the lamination direction of the ceramic layers can be controlled and prevented, and the solder can be reliably held at the side surface of the multilayer module body. Accordingly, the bonding strength of the metal case with respect to the multilayer module body can be further markedly improved, thereby making the present invention further effective.

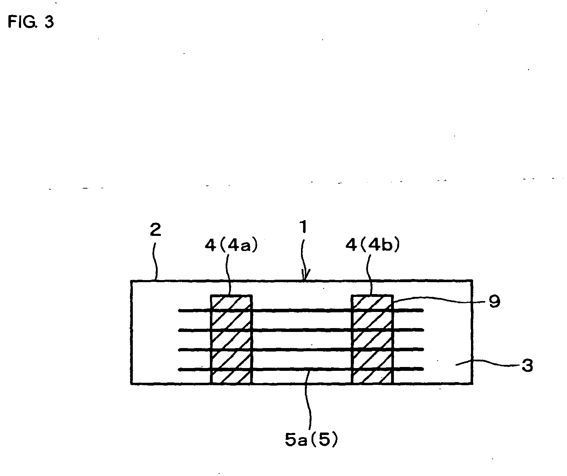

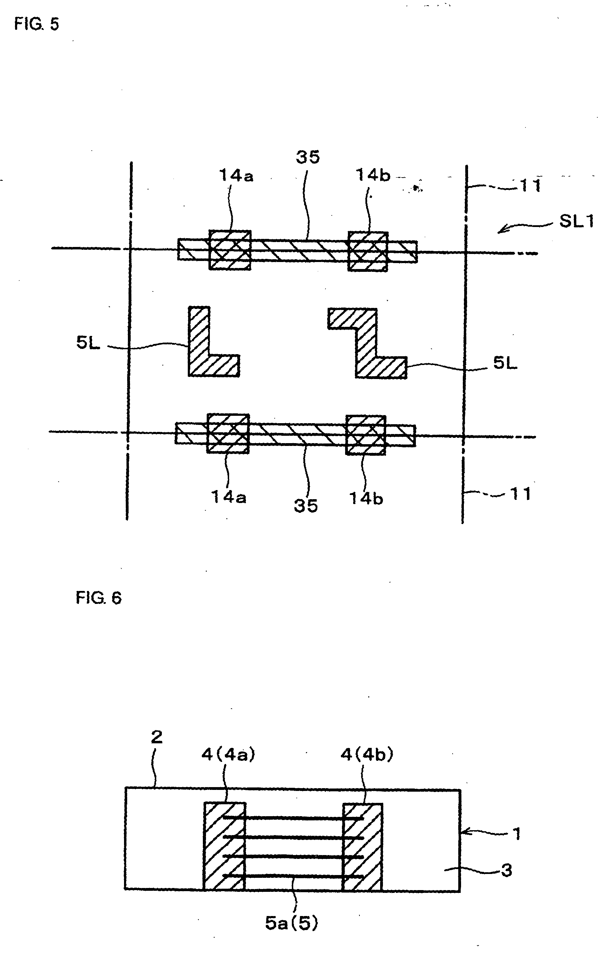

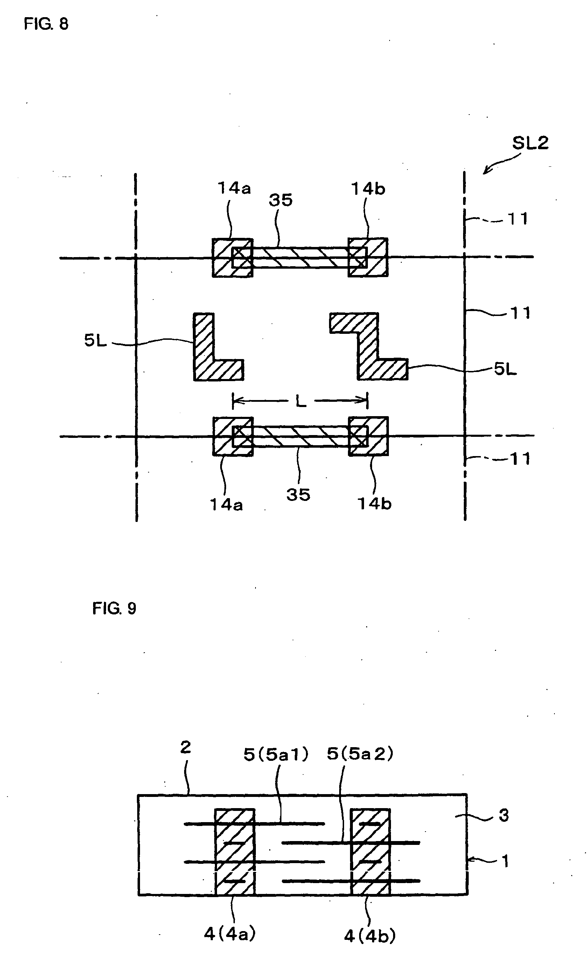

It should be noted that the expression, "the plurality of inner conductor layers are exposed at the side surface such that at least the part of the inner conductor layer is superposed on the other inner conductor layer when seen in the lamination direction of the ceramic layers", means various cases involving a case where the plurality of inner conductor layers extend from one to the other of the pair of side electrodes as shown in Figs. 3 and 6; and a case where an inner conductor layer extending from the one side electrode toward the other side electrode but not reaching to the other side electrode is provided, an inner conductor layer extending from the other side electrode toward the one side electrode but not reaching to the one side electrode is provided, and tip end portions of both inner conductor layers are superposed when seen in the lamination direction of the ceramic layers, as shown in Fig. 9; etc.

Also, based on the configuration of the invention according to claim 1, like the covered multilayer module according to claim 3, the case is shown where the inner conductor layer is exposed at the side surface of the multilayer module body such that the inner conductor layer extends from one to the other of the adjacently arranged pair of side electrodes. In such a case, the solder can be further reliably held at the region interposed between the pair of side electrodes, thereby sufficiently securing the bonding strength of the metal case with respect to the multilayer module body. Accordingly, a further highly reliable covered multilayer module can be provided.

In addition, in the present invention, the inner conductor layer may be exposed at the side surface such that the inner conductor layer extends from one to the other of the adjacently arranged pair of side electrodes, and extend to the outside of the pair of side electrodes. In such a case, the area of soldering can be increased, and the solder-holding capability can be improved. Therefore, the present invention can be further effective.

### Brief Description of the Drawings

Fig. 1 is a perspective view showing a configuration of a covered multilayer module according to an embodiment of the present invention.
Fig. 2 is an exploded perspective view showing a configuration of a covered multilayer module according to a first embodiment of the present invention.
Fig. 3 is an illustration showing a side surface of a multilayer board (multilayer module body) of the covered multilayer module according to the first embodiment of the present invention.
Fig. 4 is an illustration showing a method of allowing a ground-electrode inner-conductor layer to be exposed at the side surface of the multilayer module body, in a manufacturing procedure of the covered multilayer module according to an embodiment of the present invention.
Fig. 5 is an illustration showing a method of allowing an inner-conductor layer to be exposed at the side surface of the multilayer module body when the inner-conductor layer is coplanar with a wiring inner-conductor, in the manufacturing procedure of the covered multilayer module according to the first embodiment of the present invention.
Fig. 6 is an illustration showing a side surface of a multilayer board (multilayer module body) of a covered multilayer module according to another embodiment (second embodiment) of the present invention.
Fig. 7 is an illustration showing a method of allowing a ground-electrode inner-conductor layer to be exposed at the side surface of the multilayer module body, in a manufacturing procedure of the covered multilayer module according to the second embodiment of the present invention.
Fig. 8 is an illustration showing the method of allowing an inner-conductor layer to be exposed at the side surface of the multilayer module body when the inner-conductor layer is coplanar with a wiring inner-conductor, in the manufacturing procedure of the covered multilayer module according to the second embodiment of the present invention.
Fig. 9 is an illustration showing a side surface of a multilayer board (multilayer module body) of a covered multilayer module according to still another embodiment (third embodiment) of the present invention.
Fig. 10 is an illustration showing a method of allowing a ground-electrode inner-conductor layer to be exposed at the side surface of the multilayer module body, in a manufacturing procedure of the covered multilayer module according to the third embodiment of the present invention.
Fig. 11 is an illustration showing a method of allowing an inner-conductor layer to be exposed at the side surface of the multilayer module body when the inner-conductor layer is coplanar with a wiring inner-conductor, in the manufacturing procedure of the covered multilayer module according to the third embodiment of the present invention.
Fig. 12 is an illustration showing an attachment structure of a metal case of a covered multilayer module according to a related art.
Fig. 13 is an enlarged illustration showing a primary portion of the covered multilayer module according to the related art.

### Reference Numerals

- 1: multilayer module body (multilayer board)
- 2: first principal surface (upper surface)
- 3: side surface
- 4: (4a, 4b) side electrode
- 5: inner conductor layer
- 5a: end of inner conductor layer (inner conductor exposed portion)
- 5a1: inner conductor exposed portion
- 5a2: inner conductor exposed portion
- 5G: ground-electrode inner-conductor layer (ground electrode)
- 5G1: upper-side protrusion
- 5G2: lower-side protrusion
- 5G3, 5G4: protrusion
- 5L: wiring inner-conductor layer
- 6: solder
- 8: second principal surface (lower surface)
- 9: recess
- 11: child board
- 14a, 14b: through hole
- 21: metal case
- 22: claw portion
- 31: mount device
- 35: floating electrode
- SG1, SL1: ceramic green sheet
- SG2, SL2: ceramic green sheet
- SG3, SL3: ceramic green sheet
- L, L1: length of floating electrode
- W: width of upper-side protrusion, width of lower-side protrusion
- W1, W2: width of protrusion
- WT: width of through hole

### Best Mode for Carrying Out the Invention

Features of the present invention are described below in more detail with reference to embodiments of the present invention.

### First Embodiment

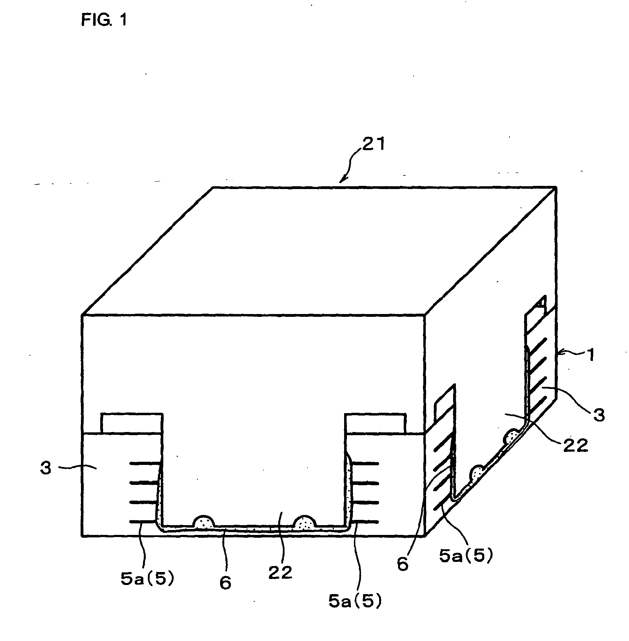

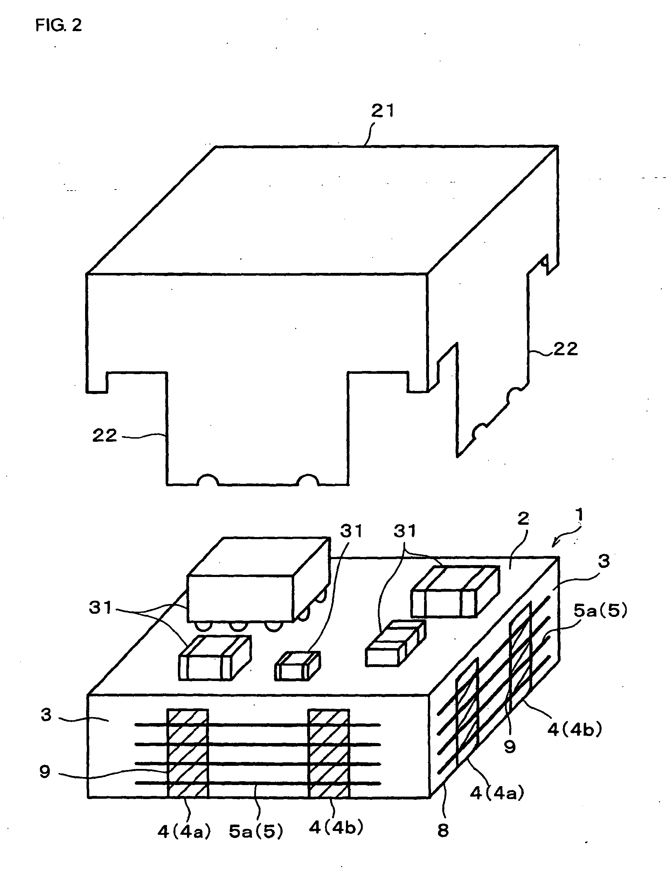

Fig. 1 is a perspective view showing a configuration of a covered multilayer module according to an embodiment of the present invention, and Fig. 2 is an exploded perspective view of Fig. 1.

As shown in Figs. 1 and 2, this covered multilayer module includes a multilayer module body (multilayer board) 1 in which mount devices 31 are mounted on a first principal surface (upper surface) 2 of the multilayer module body 1, and a metal case 21 arranged to cover the first principal surface 2 of the multilayer module body 1.

The metal case 21 is fixed to the multilayer module body 1 by connecting a claw portion 22 of the metal case 21 to side electrodes 4 disposed at a side surface 3 of the multilayer module body 1 and to inner conductor layers 5 (hereinafter, also referred to as inner conductor exposed portions 5a) exposed at the side surface 3, using solder 6.

The configuration of the covered multilayer module is described below more specifically.

In the covered multilayer module of this embodiment, the multilayer module body 1 is formed by laminating a plurality of ceramic layers each having an inner conductor layer with a predetermined pattern formed (printed) on the surface. Lands (not shown) for mounting mount devices are provided on the first principal surface (upper surface) 2, so that the mount devices 31, such as an IC chip, a chip filter, a chip condenser, a chip resistance, and the like, are mounted on the lands.

Outer electrodes (not shown) by which the multilayer module is to be connected to other board or the like are formed on a second principal surface (lower surface) 8 of the multilayer module body 1.

The side electrodes 4, to which the claw portion 22 of the metal case 21 is bonded, are disposed at the side surface 3 of the multilayer module body 1. The side electrodes 4 are made of an electrode material filled in recesses 9. The electrode material of the side electrodes 4 is the same as that of the inner conductor layers 5.

In this embodiment, two side electrodes 4 (4a, 4b) are provided at each side surface 3 of the multilayer module body 1.

In this embodiment, the side electrodes 4 (4a, 4b) are formed by baking conductive paste filled in the recesses formed at the side surface 3 of the multilayer module body.

Also, the inner conductor layers 5 disposed in the multilayer module body 1, in particular, ends (inner conductor exposed portions) 5a of the inner conductor layers 5, are exposed at the side surface 3 of the multilayer module body 1. Each of the plurality of exposed inner conductor layers 5 (5a) extends from one side electrode 4a to the other side electrode 4b so as to be connect with the side electrodes 4a and 4b, and extends to regions outside the side electrodes 4a and 4b.

In this embodiment, the plurality of inner conductor layers 5 (5a) are exposed at the side surface 3 of the multilayer module body 1. Each of the plurality of inner conductor layers 5 (5a) exposed at the side surface 3 extends from one to the other of the adjacently arranged pair of side electrodes 4a and 4b, and extends to the regions outside the side electrodes 4a and 4b.

The multilayer module of this embodiment includes, as the inner conductor layers 5, a wiring inner-conductor layer, and a ground-electrode inner-conductor layer. In general, a predetermined layer among the inner conductor layers 5 for ground electrodes is exposed at the side surface 3 of the multilayer module body 1, as required.

In the multilayer module having such a configuration, the plurality of inner conductor layers 5 (5a) are exposed at the side surface 3 of the multilayer module body 1 in a region interposed between the adjacently arranged pair of side electrodes 4 (4a, 4b), and the claw portion 22 of the metal case 21 is soldered to the two side electrodes 4 (4a, 4b) and the inner conductor layers 5 (5a) exposed at the side surface 3 of the multilayer module body 1. Accordingly, the claw portion 22 of the metal case 21 is soldered not only to the side electrodes 4 (4a, 4b), but also to the inner conductor layers 5 (5a), and the plurality of inner conductor layers 5 (5a) exposed at the side surface 3 allow the solder 6 to be held at the side surface 3 of the multilayer module body 1. This may allow the bonding strength of the metal case 21 with respect to the multilayer module body 1 to be sufficiently secured, thereby providing a highly reliable covered multilayer module, without a manufacturing procedure being complicated due to use of a special member, or a product being increased in size due to increase in the area of the side electrodes.

Next, a method of manufacturing the multilayer module is described.

### [Fabrication of Ceramic Green Sheet with Inner conductor Layer Printed]

First, mother ceramic green sheets for forming the multilayer module body 1, in particular, a ceramic green sheet having printed thereon a ground-electrode inner-conductor layer 5G (hereinafter, also merely referred to as "ground electrode 5G"), and a ceramic green sheet having printed thereon a wiring inner-conductor layer, are prepared.

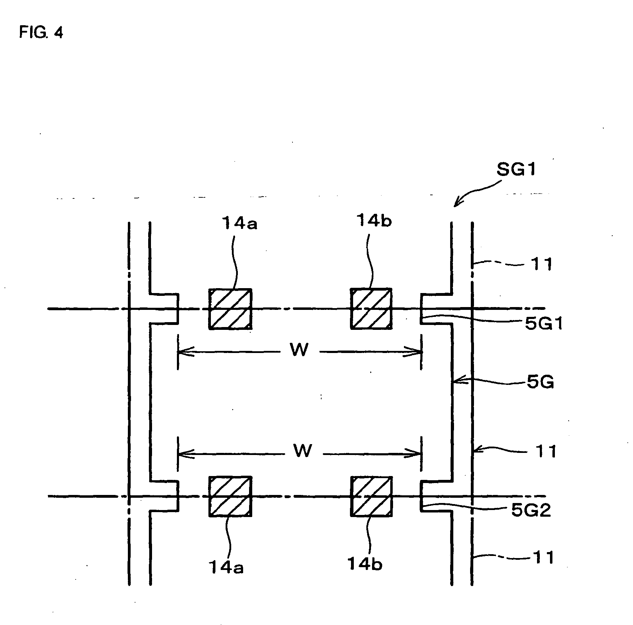

At this time, as shown in Fig. 3, in order to allow the inner conductor exposed portions 5a to be exposed at the side surface 3 of the multilayer module body 1 such that each of the inner conductor exposed portions 5a extends from one side electrode 4a to the other side electrode 4b so as to be connected to the side electrodes 4a and 4b, and extends to the regions outside the side electrodes 4a and 4b, a ceramic green sheet SG1 (Fig. 4) and a ceramic green sheet SL1 (Fig. 5) are prepared. The ceramic green sheet SG1 for a plurality of child boards 11 has through holes 14a and 14b (Fig. 4) formed at positions where the recesses for forming side electrodes are formed, and the ground-electrode inner-conductor layer 5G for the plurality of child boards 11, which is printed thereon in a matrix form. The ceramic green sheet SL1 for another plurality of child boards 11 has through holes 14a and 14b (Fig.4) formed at positions where the recesses for forming side electrodes are formed, and the wiring inner-conductor layer 5L for the other plurality of child boards 11, which is printed thereon in a matrix form.

In the ceramic green sheet SG1 on which the ground-electrode inner-conductor layer 5G is formed, as shown in Fig. 4, the pair of through holes 14a and 14b for forming side electrodes are formed at the positions where the recesses for forming the side electrodes 4 (Fig. 3) are formed, for example, at upper and lower boundary portions with respect to the adjacent child boards 11.

The print pattern of the ground-electrode inner-conductor layer 5G is a print pattern in which an upper-side protrusion 5G1 and a lower-side protrusion 5G2 extend to ends of the child board 11 (in Fig. 4, upper and lower ends), and are connected to the ground electrode 5G of the adjacent child boards 11. A width W of the upper-side protrusion 5G1 and that of the lower-side protrusion 5G2 of the ground electrode 5G are determined so that the upper-side protrusion 5G1 and the lower-side protrusion 5G2 each protrude to the outside of oppositely located, not facing ends of the pair of through holes 14a and 14b.

When the conductive paste is printed on the ceramic green sheet SG1 to form the ground-electrode inner-conductor layer 5G, the conductive paste is also printed on the through holes 14a and 14b, so as to form electrodes, which become the side electrodes after dividing.

In the ceramic green sheet SL1 having printed thereon the wiring inner-conductor layer 5L, in order to allow the inner conductor exposed portions 5a to be exposed in a manner shown in Fig. 3, below-described floating electrodes 35 and 35 are formed in addition to the wiring inner-conductor layer 5L.

In particular, as shown in Fig. 5, a pair of through holes 14a and 14b for forming side electrodes are formed at the ceramic green sheet SL1, which becomes a layer provided with the wiring inner-conductor layer 5L, at positions where the recesses for forming side electrodes are formed, for example, at the upper and lower boundary portions with respect to the adjacent child boards 11.

Then, the conductive paste for forming the wiring inner-conductor layer 5L is printed in a predetermined region, and the conductive paste is also printed in regions including the through holes 14a and 14b. Accordingly, the band-like floating electrodes 35 and 35 are formed, each extending from a region outside the outer end of one through hole 14a to a region outside the outer end of the other through hole 14b. Also, the through holes 14a and 14b are filled with the conductive paste, to form electrodes, which become the side electrodes after dividing.

When preparing the ceramic green sheets SG1 and SL1, via holes for inter-layer connection are formed at the same time if necessary. The via holes are filled with conductive paste same as that for forming the inner conductor layers, to form via hole conductors.

### [Lamination and Firing of Ceramic Green Sheet]

Next, ceramic green sheets (including a ceramic green sheet on which an inner conductor layer is not printed) including the ceramic green sheets SG1 and SL1 having printed thereon the inner conductor layers (inner conductor patterns) as described above are laminated in a predetermined order to form a mother laminated body, and then the mother laminated body is fired under a predetermined condition.

### [Mounting of Mount Device and Dividing]

Next, mount devices are mounted on the child boards (multilayer module bodies) of the fired mother laminated body.

Then, the mother laminated body is divided at the boundary portions with respect to the adjacent child boards 11.

Accordingly, as shown in Fig. 2, the multilayer module body 1 can be provided in which the mount devices 31 arse mounted, and the side electrodes 4 (4a, 4b) and the inner conductor exposed portions 5a are exposed at the side surface 3 in the above-described manner (see Fig. 3).

### [Attachment of Metal Case]

Next, as shown in Figs. 1 and 2, the metal case 21 is attached to the multilayer module body 1, and the solder 6 is applied to the side surface 3 of the multilayer module body 1 in the vicinities of the side electrodes 4 and the inner conductor exposed portions 5a, i.e., the solder 6 is applied to the bonding portion between the claw portion 22 of the metal case 21 and the multilayer module body 1. Then, by reflowing, the claw portion 22 of the metal case 21 is soldered to the side electrodes 4 and the inner conductor exposed portions 5a at the side surface 3 of the multilayer module body 1, so that the metal case 21 is bonded and fixed to the multilayer module body 1. Accordingly, the multilayer module having the structure as shown in Figs. 1 and 2 can be provided.

In the first embodiment, while the inner conductor pattern, which becomes the exposed inner conductor layer, is provided on the layer provided with the ground electrode 5G and on the layer provided with the wiring inner-conductor layer 5L, at least one inner conductor pattern, which becomes the exposed inner conductor layer, may be provided at a desired layer.

### Second Embodiment

Fig. 6 is an illustration showing a structure of a side surface of a multilayer module body of a multilayer module according to another embodiment (second embodiment) of the present invention.

In the multilayer module of the second embodiment, as shown in Fig. 6, each of the plurality of inner conductor layers 5 exposed at the side surface 3 of the multilayer module body 1 extends from one to the other of an adjacently arranged pair of side electrodes 4a and 4b, but does not extend to the regions outside the side electrodes 4a and 4b.

Such a multilayer module according to the second embodiment may be manufactured, for example, by a method described below.

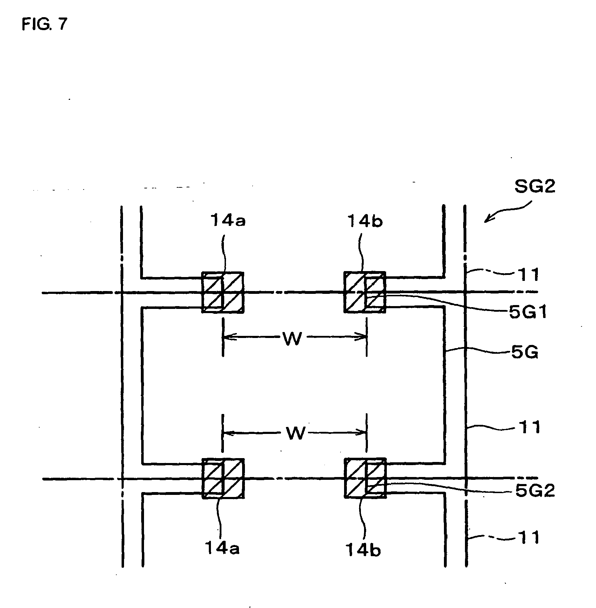

First, a ceramic green sheet SG2 having printed thereon a ground-electrode inner-conductor layer 5G as shown in Fig. 7, and a ceramic green sheet SL2 having printed thereon a wiring inner-conductor layer 5L as shown in Fig. 8, are prepared as mother ceramic green sheets for forming the multilayer module body 1.

A mother ceramic green sheet SG2 havingprinted thereon a ground-electrode inner-conductor layer 5G is, as shown in Fig. 7, configured such that a pair of through holes 14a and 14b for forming side electrodes are formed at positions where recesses for forming side electrodes are formed, for example, at the upper and lower boundary portions with respect to the adjacent child boards 11. The upper-side protrusion 5G1 and the lower-side protrusion 5G2 extend to ends (in Fig. 7, upper and lower ends) of each child board 11, and are connected to the ground electrode 5G of the adjacent child boards 11. A width W of an upper-side protrusion 5G1 and that of a lower-side protrusion 5G2 of the ground electrode 5G are determined so that each of the upper-side protrusion 5G1 and the lower-side protrusion 5G2 extends from one through hole 14a to the other through hole 14b but does not protrude to the outside of outer ends of the through holes 14a and 14b. Also, the through holes 14a and 14b are filled with conductive paste for forming side electrode.

A mother ceramic green sheet SL2 having printed thereon a wiring inner-conductor layer 5L is, as shown in Fig. 8, configured such that a pair of through holes 14a and 14b for forming side electrodes are formed at positions where recesses for forming side electrodes are formed, for example, at the upper and lower boundary portions with respect to the adjacent child boards 11. Also, the wiring inner-conductor layer 5L is disposed, and band-like floating electrodes 35 and 35 are provided, each extending from the one through hole 14a to the other through 14b formed at each of the boundary portions with respect to the adjacent child boards 11, but not protruding to the outside of the outer ends of the through holes 14a and 14b. The length L of the floating electrodes 35 and 35 is substantially the same as the width W of the upper-side protrusion 5G1 and that of the lower-side protrusion 5G2 of the ground electrode 5G.

Next, the ceramic green sheets SG2 and SL2 with the configurations as shown in Figs. 7 and 8 are laminated, and then, by applying a method similar to that of the first embodiment, as shown in Fig. 6, the multilayer module body 1 can be obtained in which each of the plurality of inner conductor layers 5 exposed at the side surface 3 of the multilayer module body 1 extends from one to the other of the adjacently arranged pair of side electrodes 4a and 4b, but does not extend to the regions outside the side electrodes 4a and 4b.

Then, the metal case is bonded and fixed to the multilayer module body 1 in a manner similar to the first embodiment, thereby obtaining a highly reliable multilayer module having a large bonding strength of the metal case like the first embodiment.

With the multilayer module according to the second embodiment, advantages similar to those of the first embodiment can be obtained.

### Third Embodiment

Fig. 9 is an illustration showing a structure of a side surface of a multilayer module body of a multilayer module according to still another embodiment (third embodiment) of the present invention.

As shown in Fig. 9, in the multilayer module of the third embodiment, two side electrodes 4 (4a and 4b), and an inner conductor exposed portion 5a1 as well as an inner conductor exposed portion 5a2, are provided at a side surface 3 of a multilayer module body 1. The inner conductor exposed portion 5a1 protrudes from left and right ends of one side electrode 4a but does not reach to the other side electrode 4b. The inner conductor exposed portion 5a2 protrudes from left and right ends of the other side electrode 4b, but does not reach to the one side electrode 4a. Tip end portions of the inner conductor exposed portions 5a1 and 5a2 located between the side electrodes 4a and 4b are disposed so as to be superposed when seen in a lamination direction of ceramic layers.

Such a multilayer module according to the third embodiment may be manufactured, for example, by a method described below.

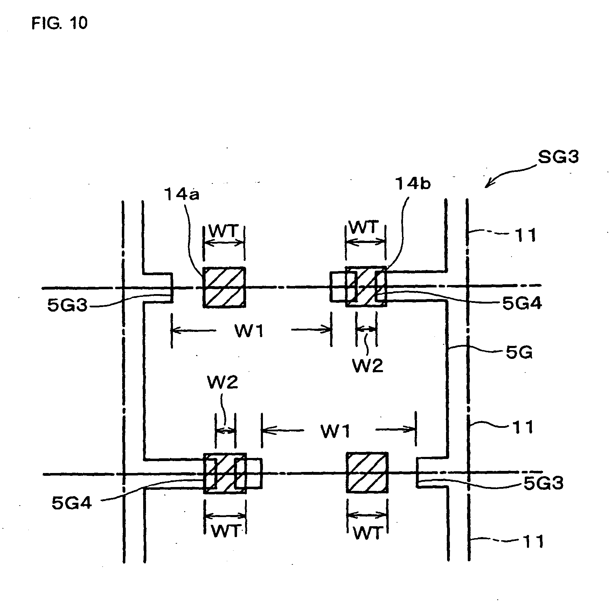

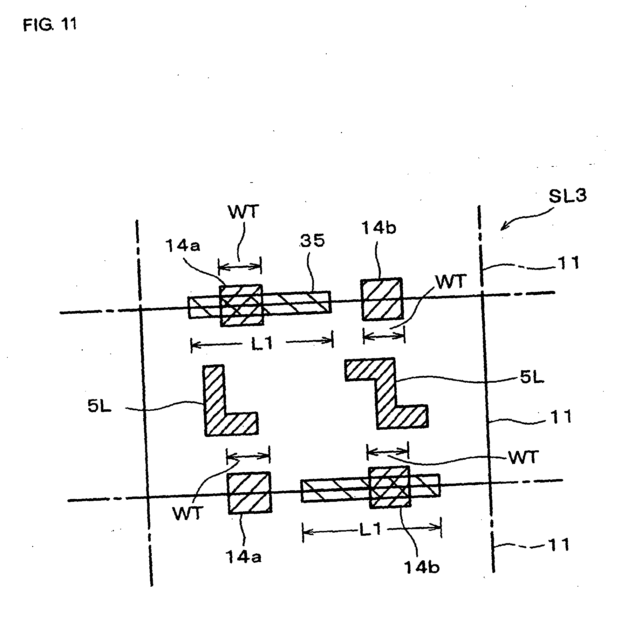

First, a ceramic green sheet SG3 having printed thereon a ground-electrode inner-conductor layer 5G as shown in Fig. 10, and a ceramic green sheet SL3 having printed thereon a wiring inner-conductor layer 5L as shown in Fig. 11, are prepared as mother ceramic green sheets for forming the multilayer module body 1.

A ceramic green sheet SG3 having printed thereon the ground-electrode inner-conductor layer 5G is, as shown in Fig. 10, configured such that a pair of through holes 14a and 14b for forming side electrodes are formed at positions where recesses for forming side electrodes are formed, for example, at upper and lower boundary portions with respect to adjacent child boards 11, and a protrusion 5G3 and a protrusion 5G4 are provided in each of upper and lower regions including the through holes 14a and 14b. The protrusion 5G3 has a width W1 which is greater than a width WT of the through holes 14a and 14b. The protrusion 5G4 has a width W2 which is smaller than the width WT of the through holes 14a and 14b. The ground-electrode inner-conductor layer 5G is printed such that the positional relationship between the two protrusions 5G3 and 5G4 having the different widths is bilaterally symmetrical at the upper and lower portions. Also, the through holes 14a and 14b are filled with conductive paste for forming side electrode.

A ceramic green sheet SL3 having printed thereon the wiring inner-conductor layer 5L is, as shown in Fig. 11, configured such that a pair of through holes 14a and 14b for forming side electrodes are formed at positions where recesses for forming side electrodes are formed, for example, at each of upper and lower boundary portions with respect to adjacent child boards 11. Also, band-like floating electrodes 35 and 35 are provided at the upper and lower portions. One floating electrode 35 in the upper portion of the single child board 11 has a length L1 substantially same as the width W1 of the protrusion 5G3 at the upper portion of the ground electrode 5G so that the one floating electrode 35 is only superposed on one through hole 14a, and protrudes from left and right ends of the one through hole 14a. The other floating electrode 35 in the lower portion has a length L1 substantially same as the width W1 of the protrusion 5G3 at the lower portion of the ground electrode 5G so that the other floating electrode 35 is only superposed on the other through hole 14b, and protrudes from left and right ends of the other through hole 14b.

Though not particularly illustrated, a mother ceramic green sheet to be laminated at lower and upper layers of the above-described ceramic green sheets is prepared. In the ceramic green sheet, band-like floating electrodes 35 and 35 are provided at upper and lower portions such that one floating electrode 35 in the upper portion of the single child board 11 is only superposed on the other through hole 14b and protrudes from the left and right ends of the other through hole 14b, and the other floating electrode 35 in the lower portion is only superposed on the one through hole 14a and protrudes from the left and right ends of the one through hole 14a, in a manner opposite to the above described green sheet shown in Fig. 11. Namely the configuration of the ceramic green sheet is the same as the one of the ceramic green sheet shown in Fig. 11 rotated at 180° in plan view. The ceramic green sheet shown Fig. 11 can be practically used as the green sheets to be laminated on the upper and lower layers of predetermined green sheets.

These ceramic green sheets are laminated, and thereafter, a method similar to that of the first embodiment is applied. Accordingly, as shown in Fig. 9, the multilayer module body 1 can be provided, which has a configuration such that the side electrodes 4a and 4b, and the inner conductor exposed portion 5a1 as well as the inner conductor exposed portion 5a2 are provided at the side surface 3 of the multilayer module body 1, and the tip end portions of the inner conductor exposed portions 5a1 and 5a2 located between the side electrodes 4a and 4b are superposed when seen in the lamination direction of the ceramic layers.

Then, the metal case is bonded and fixed to the multilayer module body 1 in a manner similar to the first embodiment, thereby obtaining a highly reliable multilayer module having a large bonding strength of the metal case like the first embodiment.

With the multilayer module according to the third embodiment, advantages similar to those of the first embodiment can be obtained.

In the above-described embodiments, while the inner conductor exposed portion 5a is exposed at the layer provided with the ground electrode 5G and at the layer provided with the wiring inner-conductor layer 5L, the inner conductor exposed portion 5a may be exposed only at one of these layers.

Regarding the number of layers desired to be exposed, the inner conductor layers may be exposed at desired layers composed of one type or both types of layers.

In particular, with the present invention, the inner conductor exposed portion may be formed in either manner or both manners listed below:
(1) a method of forming the inner conductor exposed portion using the ground electrode, and
(2) a method of allowing the inner conductor exposed portion to be exposed at the side surface from the layer provided with the wiring inner-conductor layer.

In the case where the inner conductor layer is printed on the ceramic green sheet, the printing procedure does not become complicated even if the inner conductor layer, which becomes the inner conductor exposed portion, is printed at the same time. Accordingly, by printing the inner conductor layers, which become the inner conductor exposed portions, at the same time on the layer on which the ground-electrode inner-conductor layer is printed and on the layer on which the wiring inner-conductor layer is printed, and allowing the inner conductor exposed portions to be exposed at the layers provided with the inner conductor layers, the multilayer module can be efficiently manufactured in which many inner conductor exposed portions are exposed at the side surface of the multilayer module body and the metal case is bonded to the multilayer module with high reliability.

The present invention is not limited to the above-described embodiments, and various applications and modifications can be made within the scope of the invention, for the specific configuration of the multilayer module body (for example, the lamination condition of the ceramic layer and the inner conductor layer, the specific shape of the inner conductor layer, the type and mounting manner of the mount devices, and the like), the shape of the exposed portion of the side electrode and the inner conductor layer, the positional relationship between the side electrode and the inner conductor layer, the specific structure of the metal case, and the like.

### Industrial Applicability

As described above, with the present invention, the highly reliable multilayer module can be provided in which the bonding strength of the metal case with respect to the multilayer module body is improved, without using a special member or increasing in size of a product for increasing the area of the side electrode.

Therefore, the present invention can be applied widely to covered multilayer modules used for various purposes.

## Claims

1. A covered multilayer module comprising:
a multilayer module body (1) in which a mount device is mounted on a multilayer board; and
a metal case (21) arranged to cover at least one of principal surfaces of the multilayer module body,
wherein the multilayer module body has a plurality of laminated ceramic layers and at least one inner conductor layer (5), the inner conductor layer being formed between the ceramic layers, the multilayer module body has a shape defined by a pair of opposite principal surfaces (2, 8) and side surfaces (3) connecting the pair of principal surfaces, a plurality of side electrodes (4a, 4b) extending in a lamination direction of the ceramic layers are provided at least at one of the side surfaces, and at least one of the inner conductor layers (5a) is exposed at the side surface provided with the plurality of side electrodes, in a region interposed between an adjacently arranged pair of the side electrodes, and
wherein the metal case has a top plate and a claw portion (22), the claw portion is formed to extend along the side surface of the multilayer module body provided with the side electrodes, **characterized in that** and the claw portion is soldered to the side electrodes and the inner conductor layer exposed at the side surface.

2. The covered multilayer module according to claim 1, wherein the plurality of inner conductor layers (5a1, 5a2) are exposed at the side surface of the multilayer module body in the region interposed between the adjacently arranged pair of side electrodes (4a, 4b) such that at least a part of the inner conductor layer is superposed on the other inner conductor layer when seen in the lamination direction of the ceramic layers.

3. The covered multilayer module according to claim 1, wherein the inner conductor layer (5a) is exposed at the side surface of the multilayer module body such that the inner conductor layer extends from one to the other of the adjacently arranged pair of side electrodes (4a, 4b).

## Patentansprüche

1. Ein ummanteltes Mehrschichtmodul, das folgende Merkmale umfasst:
einen Mehrschichtmodulkörper (1), in dem eine Befestigungsvorrichtung auf einer Mehrschichtplatine befestigt ist: und
ein Metallgehäuse (21), das angeordnet ist, um zumindest eine der Hauptoberflächen des Mehrschichtmodulkörpers zu ummanteln,
wobei der Mehrschichtmodulkörper eine Mehrzahl von laminierten Keramikschichten und zumindest eine Innenleiterschicht (5) aufweist, wobei die Innenleiterschicht zwischen den Keramikschichten gebildet ist, wobei der Mehrschichtmodulkörper eine Form aufweist, die definiert ist durch ein Paar von gegenüberliegenden Hauptoberflächen (2. 8) und Seitenoberflächen (3), die das Paar von Hauptoberflächen verbinden, wobei eine Mehrzahl von Seitenelektroden (4a, 4b), die sich in einer Laminierungsrichtung der Keramikschichten erstreckt, an zumindest einer der Seitenoberflächen vorgesehen ist, und zumindest eine der Innenleiterschichten (5a) an der Seitenoberfläche freigelegt ist, die mit der Mehrzahl von Seitenelektroden versehen ist, in einer Region, die zwischen einem benachbart angeordneten Paar der Seitenelektroden liegt, und
wobei das Metallgehäuse eine obere Platte und einen Klauenabschnitt (22) aufweist,
wobei der Klauenabschnitt gebildet ist, um sich entlang der Seitenoberfläche des Mehrschichtmodulkörpers zu erstrecken, die mit den Seitenelektroden (1) verstehen ist, **dadurch gekennzeichnet, dass** der Klauenabschnitt an die Seitenelektroden gelötet ist und die Innenleiterschicht an der Seitenoberfläche freigelegt ist.

2. Das ummantelte Mehrschichtmodul gemäß Anspruch 1, bei dem die Mehrzahl von Innenleiterschichten (5a1, 5a2) an der Seitenoberfläche des Mehrschichtmodulkörpers in der Region freigelegt ist, die zwischen dem benachbart angeordneten Paar von Seitenelektroden (4a. 4b) liegt, so dass von der Laminierungsrichtung der Keramikschichten aus gesehen zumindest ein Teil der Innenleiterschicht die andere Innenleiterschicht überlagert.

3. Das ummantelte Mehrschichtmodul gemäß Anspruch 1, bei dem die Innenleiterschicht (5a) an der Seitenoberfläche des Mehrschichtmodulkörpers freigelegt ist, so dass sich die Innenleiterschicht von einer zu der anderen des benachbart angeordneten Paars von Seitenelektroden (4a, 4b) erstreckt.

## Revendications

1. Module multicouche recouvert comportant :
un corps de module multicouche (1) dans lequel un dispositif de montage est monté sur une plaque multicouche ; et
un boîtier métallique (21) agencé pour recouvrir au moins une des surfaces principales du corps de module multicouche,
dans lequel le corps de module multicouche possède une pluralité de couches céramiques stratifiées et au moins une couche conductrice interne (5), la couche conductrice interne étant formée entre les couches céramiques, le corps de module multicouche possède une forme définie par une paire de surfaces principales opposées (2, 8) et de surfaces latérales (3) reliant la paire de surfaces principales, une pluralité d'électrodes latérales (4a, 4b) s'étendant dans une direction de stratification des couches céramiques sont prévues au moins sur une des surfaces latérales, et au moins une des couches conductrices internes (5a) est exposée à la surface latérale munie de la pluralité d'électrodes latérales, dans une région interposée entre une paire d'électrodes latérales disposées de façon adjacente, et
dans lequel le boîtier métallique possède une plaque supérieure et une partie de griffe (22), la partie de griffe étant formée pour s'étendre le long de la surface latérale du corps de module multicouche munie des électrodes latérales, **caractérisé en ce que** la partie de griffe est soudée aux électrodes latérales et la couche conductrice interne exposée à la surface latérale.

2. Module multicouche recouvert selon la revendication 1, dans lequel la pluralité de couches conductrices internes (5a1, 5a2) sont exposées à la surface latérale du corps de module multicouche dans la région interposée entre la paire d'électrodes latérales (4a, 4b) disposées de façon adjacente de sorte qu'au moins une partie de la couche conductrice interne est superposée sur l'autre couche conductrice interne tel qu'observé dans la direction de stratification des couches céramiques.

3. Module multicouche recouvert selon la revendication 1, dans lequel la couche conductrice interne (5a) est exposée à la surface latérale du corps de module multicouche de sorte que la couche conductrice interne s'étend de l'une à l'autre de la paire d'électrodes latérales (4a, 4b) disposées de façon adjacente.
